**Europäisches Patentamt**

**European Patent Office**

**Office européen des brevets**

(19)

(11) Veröffentlichungsnummer : **0 584 634 B1**

## EUROPÄISCHE PATENTSCHRIFT

(12)

(45) Veröffentlichungstag der Patentschrift :
20.12.95 Patentblatt 95/51

(51) Int. Cl.⁶ : **H01S 3/103**

(21) Anmeldenummer : **93112786.4**

(22) Anmeldetag : **10.08.93**

(54) **Schaltung zur Amplitudenmodulation des Ansteuersignals eines Lasers**

(30) Priorität : **17.08.92 DE 4227079**
**17.08.92 DE 4227098**

(43) Veröffentlichungstag der Anmeldung :
**02.03.94 Patentblatt 94/09**

(45) Bekanntmachung des Hinweises auf die
Patenterteilung :
**20.12.95 Patentblatt 95/51**

(84) Benannte Vertragsstaaten :
**CH DE ES FR GB IT LI SE**

(56) Entgegenhaltungen :
**DE-A- 3 508 034**
**DE-A- 3 614 691**

(73) Patentinhaber : **Alcatel SEL**
**Aktiengesellschaft**
**Lorenzstrasse 10**
**D-70435 Stuttgart (DE)**
(84) **DE**
Patentinhaber : **ALCATEL N.V.**
**Strawinskylaan 341,**
**(World Trade Center)**
**NL-1077 XX Amsterdam (NL)**
(84) **CH ES FR GB IT LI SE**

(72) Erfinder : **Nissler, Dieter**
**Bergstrasse 60**
**D-70771 Leinfelden-Echterdingen (DE)**
Erfinder : **Kaiser, Norbert**
**Calwer Strasse 58**
**D-71732 Tamm (DE)**
Erfinder : **Manz, Werner**
**Stäudachstrasse 8**
**D-70771 Leinfelden-Echterdingen (DE)**

(74) Vertreter : **Pohl, Herbert, Dipl.-Ing et al**
**Alcatel SEL AG**
**Patent- und Lizenzwesen**
**Postfach 30 09 29**
**D-70449 Stuttgart (DE)**

EP 0 584 634 B1

## Beschreibung

Die Erfindung betrifft eine Schaltungsanordnung zur Amplitudenmodulation des Ansteuersignals eines Halbleiterlasers, der in Sendestufen von optischen Nachrichtenübertragungssystemen für digitale Übertragungssignale als elektro-optischer Wandler eingesetzt wird. Beim Einsatz des Lasers in hochbitratigen Übertragungssystemen stört die von der Vorgeschichte des Lasers abhängige Einschaltzeit, die zu einem Bitmustereffekt führt. Der zu sendende Lichtimpuls wird erst nach einer gewissen Einschaltverzögerung abgegeben. Um diese Verzögerung zu verringern, wird der Laser mit einem Vorstrom betrieben, der ungefähr gleich dem Schwellenstrom des Lasers ist. Durch Temperatur- und Alterungseinflüsse ändern sich Schwellenstrom und Anstieg des steilen Teils der Laserkennlinie. Der Vorstrom soll jedoch unabhängig von diesen Einflüssen ungefähr gleich dem Schwellenstrom bleiben. Dazu ist es erforderlich, die Schwellenstromänderung zu erkennen und den Vorstrom entsprechend nachzuregeln. Ferner soll die mittlere optische Leistung unabhängig von diesen Einflüssen konstant gehalten werden, um gleichbleibende Systemdaten zu gewährleisten. Dazu muß die Änderung der Kennliniensteigung erkannt werden, um dann einen dem Vorstrom überlagerten Modulationsstrom entsprechend nachzuregeln. Durch die getrennte Regelung von Vorstrom und Modulationsstrom wird die emittierte optische Leistung temperatur- und alterungsunabhängig. Zu diesem Zweck ist ein Verfahren angegeben worden, bei dem dem eigentlichen Datensignal ein niederfrequentes Pilotsignal aufmoduliert wird, vgl. Smith, D.W. und Hodgkinson, T.G.: "Laser level control for high bit rate optical fiber systems", Proc. of IEEE, 13th International Symposium on Circuits and Systems, 28. bis 30. April 1980, Houston, Texas, Seiten 926 bis 930. Durch Auswertung der vom Laserarbeitpunkt abhängigen Verstärkung des Pilotsignals sowie der mittleren optischen Leistung werden die Stellgrößen Vorstrom und Modulationsstrom bestimmt. Geregelt wird auf die Größe des Vorstroms im Knickbereich der Laserkennlinie, das heißt, der Vorstrom wird etwa auf den Wert des Schwellenstromes geregelt.

Es ist weiterhin eine Schaltungsanordnung bekannt, mit der dem Vorstrom und dem Modulationsstrom des Lasers ein Pilotstrom überlagert wird, vgl. DE 35 08 034. Die Schaltungsanordnung besteht aus einer dreistufigen Kaskadenschaltung. Der Laser als Verbraucher ist in Serie mit den Transistoren der Kaskade geschaltet. Die erste Stufe wird entsprechend dem Pegel des Datensignals, die zweite Stufe wird entsprechend dem Pegel des Pilotsignals geschaltet. Die dritte Stufe besteht aus stromgesteuerten Stromquellen, sogenannten Stromspiegeln, deren Spiegelfaktoren durch Gegenkopplung mit Emitterwiderständen bestimmt werden.

Um eine starke Gegenkopplung und eine stabile Stromeinprägung für die Differenzverstärker der ersten und zweiten Kaskadenstufe zu erhalten, muß der Emitterwiderstand der Stromquellen sehr viel größer als der Kehrwert der Transistorsteilheit gewählt werden. Durch den daraus resultierenden Spannungsabfall am Emitterwiderstand werden die Kollektor-Emitter-Spannungen der Transistoren der Differenzverstärker und der Stromquellen bei gegebener Versorgungsspannung stark reduziert, so daß die Transistoren in den Sättigungszustand kommen.

Der Ausgangsstrom der Stromquellen bleibt konstant, solange die Transistoren nicht übersteuert werden. Die durch die Differenzverstärker realisierten Stromschalter haben dynamisch nur dann ein gutes Verhalten bezüglich Einschwingzeit und Jitter, wenn die Transistoren nicht in den Sättigungszustand kommen. Bei monolithisch integrierten Schaltungen ist bei Tranistoren im Sättigungszustand der Einfluß des dann leitend werdenden parasitären Substrattransistors nicht mehr vernachlässigbar. Die Schaltung arbeitet dann nicht mehr zuverlässig und kann völlig ausfallen. Aus diesen Bedingungen ergibt sich bei dieser Schaltungsanordnung das Problem, die Arbeitspunkte der einzelnen Transistoren so einzustellen, daß ein optimales Augendiagramm mit minimalem Zeitjitter entsteht. Die Stufenanzahl einer Kaskadenschaltung wird somit bei gegebener Versorgungsspannung begrenzt, wenn die Transistoren nicht in den Sättigungsbereich gelangen sollen. Folgende Bedingung sollte erfüllt sein:

$$U_F + n \cdot U_{BE} + U_{RE} \leqq V_{EE}$$

$U_F$      Vorwärtsspannung des Lasers

$U_{BE}$      Basis-Emitter-Spannung eines Transistors

$U_{RE}$      Spannungsabfall am Emitterwiderstand einer Stromquelle

$V_{EE}$      Versorgungsspannung

$n$      Stufenanzahl der Kaskadenschaltung

Bei der Dimensionierung einer solchen Schaltungsanordnung ist zu berücksichtigen, daß die Vorwärtsspannung eines Lasers je nach Typ bis zu 2,5 V betragen kann. Ebenso wirkt sich der nagative Temperaturkoeffizient der Basis-Emitter-Spannung der Transistoren ungünstig auf die Funktionsweise der Schaltungsanordnung aus. So nimmt beispielsweise bei -40°C die Basis-Emitter-Spannung monolithisch integrierter HF-Transistoren bei gegebenem Kollektorstrom bis auf 950 mV zu. Unter Berücksichtigung eines typischen Spannungsabfalls von 400 mV am Emitterwiderstand einer Stromquelle kann bei der angegebenen dreistufigen Kaskadenschaltung eine zuverlässige Funktion mit einer 5-V-Standard-Spannungsquelle nicht gewährleistet

EP 0 584 634 B1

werden. Vielmehr muß dann innerhalb eines optischen Senders für einen solchen Amplitudenmodulator mit einem DC/DC-Wandler eine separate Versorgungsspannung erzeugt werden.

Der Erfindung liegt die Aufgabe zugrunde, eine für handelsübliche Halbleiterlaser universell einsetzbare Schaltungsanordnung zur Amplitudenmodulation des Ansteuersignals eines Lasers anzugeben, die aus einer 5-V-Standard-Spannungsquelle versorgt werden kann und als monolithisch integrierte Schaltung realisierbar sein soll.

Diese Aufgabe wird erfindungsgemäß durch die im Hauptanspruch beschriebene Schaltungsanordnung gelöst. Einzelheiten und Varianten der Ausführungsformen sind in den Unteransprüchen beschrieben.

Das Wesen der Erfindung besteht darin, daß in einer zweistufigen Kaskadenschaltung das Datensignal und das Pilotsignal logisch so verknüpft werden, daß Vorstrom, Modulationsstrom und die beiden Pilotströme zum Laserstrom des Halbleiterlasers derart überlagert werden, daß das optische Ausgangssignal des Halbleiterlasers symmetrisch und gegenphasig amplitudenmoduliert wird und die mittlere optische Ausgangsleistung des Halbleiterlasers konstant ist.

In einer ersten Schaltungsvariante werden die als Stromschalter arbeitenden Differenzverstärker des Lasertreibers in Abhängigkeit von der logischen Verknüpfung des Datensignals mit dem Pilotsignal in der Stromschalterebene jeweils aktiviert und von den in einer zweiten Ebene angeordneten spannungsgesteuerten Stromquellen gespeist. Nur diese eine Stromschalterebene ist die einzige Signalebene mit direkter logischer Verknüpfung von Datensignal und Pilotsignal auf dieser Ebene.

In einer zweiten Schaltungsvariante werden die Differenzverstärker von dem Datensignal angesteuert und die spannungsgesteuerten Stromquellen in Abhängigkeit von dem Pilotsignal geschaltet.

Bei einer Abweichung vom so eingestellten Arbeitspunkt des Halbleiterlasers wird aus der dann mit der Frequenz des Pilotsignals schwankenden mittleren optischen Ausgangsleistung ein Steuersignal abgeleitet, mit dem eine Nachregelung der zum Laserstrom überlagerten Ströme so erfolgt, daß die ursprüngliche mittlere optische Ausgangsleistung wieder erreicht wird. Mit der erfindungsgemäßen Schaltungsanordnung wird ein Gleichlauf von Modulationsstrom und zwei Pilotströmen mit hoher Genauigkeit ermöglicht, so daß stets eine abgleichfreie und temperaturunabhängige Amplitudenmodulation des optischen Ausgangssignals und eine konstante mittlere optische Ausgangsleistung des Halbleiterlasers über den gesamten Betriebstemperaturbereich gewährleistet wird. Mit einer nur zweistufigen und in ihrem Aufbau sehr einfachen Kaskadenschaltung wird ermöglicht, daß auch unter worst-case-Bedingungen bei Verwendung einer 5V-Standard-Spannungsquelle und in einem Temperaturbereich von T = -40°C bis 100°C die Transistoren der Differenzverstärker und der spannungsgesteuerten Stromquellen außerhalb ihres Sättigungsbereiches arbeiten und somit auch ihre Schaltgeschwindigkeit nicht eingeschränkt wird. Das Pilotsignal kann wie das Datensignal mit hohen Frequenzen übertragen werden.

Mit der erfindungsgemäßen Schaltungsanordnung wird im Vergleich zu bekanntgewordenen Schaltungsanordnungen eine bessere Impulsform der übertragenen Signale erreicht. Die Schaltungsanordnung ist mit npn-Transistoren einheitlicher Technologie realisierbar und kann vollständig monolithisch integriert werden. Dabei ist die vergleichsweise geringe Versorgungsspannung von Vorteil, da diese durch den verringerten Leistungsumsatz zu einer Erhöhung der Zuverlässigkeit der integrierten Schaltung beiträgt. Es ist problemlos möglich, die Schaltungsanordnung von zwei Eingangsvariablen auf n Eingangsvariable für maximal $2^n$ Zustände des optischen Ausgangssignals systematisch zu erweitern (siehe Anspruch 5).

Die Erfindung wird nachstehend an Ausführungsbeispielen erläutert. In der dazugehörigen Zeichnung zeigen:

Fig. 1    ein Prinzipschaltbild einer erfindungsgemäßen Schaltungsanordnung mit einer Logikschaltung,

Fig. 2    ein Zeitdiagramm eines Pilotsignals, eines beispielhaften Datensignals, eines amplitudenmodulierten Laserstromes und eine Darstellung der vier Zustände der optischen Ausgangsleistung,

Fig. 3    eine Laserkennlinie $P_{opt}$ = f ($I_F$) mit der Darstellung der Einhüllenden des Laserstroms und der Einhüllenden der optischen Leistung,

Fig. 4    eine erfindungsgemäße Schaltungsanordnung, bei der die Logikschaltung mit UND-Gattern realisiert ist,

Fig. 5    eine erfindungsgemäße Schaltungsanordnung, bei der die Logikschaltung mit ODER-Gattern realisiert ist,

Fig. 6    ein Detailschaltbild der erfindungsgemäßen Schaltungsanordnung mit Logikschaltung,

Fig. 7    ein Schaltbild einer erfindungsgemäßen Schaltungsanordnung mit gesteuerten Differenzverstärkern und gesteuerten Stromquellen und

Fig. 8    ein Ausschnitt aus einem Schaltbild für eine Variante der Schaltungsanordnung in Fig. 7.

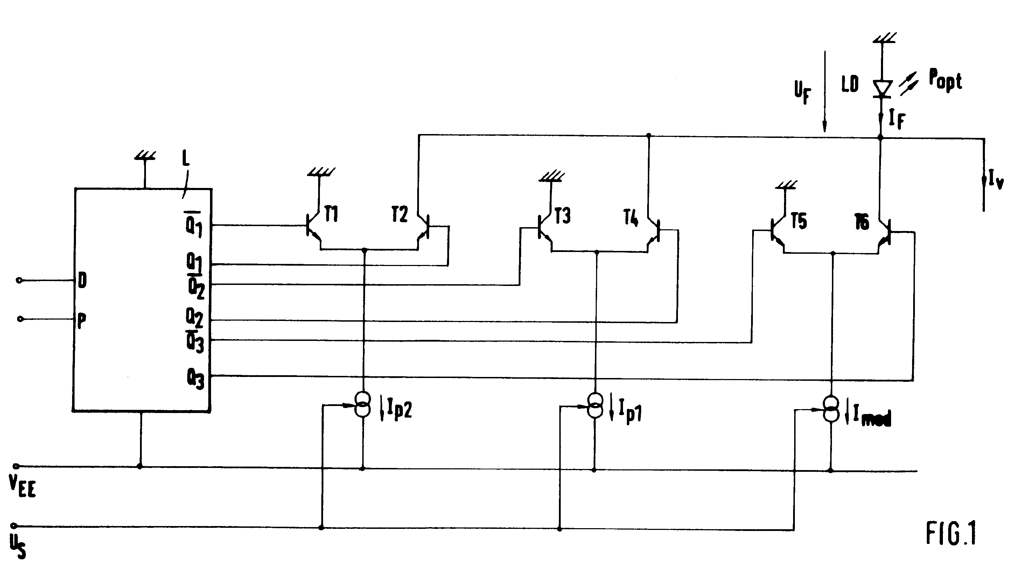

Gemäß Fig. 1 besteht die Schaltungsanordnung zur Amplitudenmodulation des Ansteuersignals eines Halbleiterlasers LD in einer ersten Schaltungsvariante aus einem ersten Differenzverstärker T1, T2, einem zweiten Differenzverstärker T3, T4 und einem dritten Differenzverstärker T5, T6 mit einer jeweils dazugehö-

3

rigen ersten spannungsgesteuerten Stromquelle $I_{P2}$, einer zweiten spannungsgesteuerten Stromquelle $I_{P1}$ und einer dritten spannungsgesteuerten Stromquelle $I_{mod}$ sowie einer Logikschaltung L.

Die drei Differenzverstärker sind ausgangsseitig parallel geschaltet. Der erste gemeinsame Anschlußpunkt der Kollektoren liegt dann über den Halbleiterlaser LD an dem ersten Pol der Betriebsspannungsquelle. Der zweite gemeinsame Anschlußpunkt der Kollektoren liegt direkt an dem ersten Pol der Betriebsspannungsquelle; es ist aber auch möglich, die Kollektoranschlüsse bedarfsweise über jeweils einen Widerstand mit dem ersten Pol der Betriebsspannungsquelle zu verbinden. Eingangsseitig werden die Differenzverstärker von der Logikschaltung L angesteuert. Die Logikschaltung L verknüpft das Datensignal D mit dem Pilotsignal P derart, daß die im Großsignalbetrieb als Stromschalter arbeitenden Transistoren der Differenzverstärker die beiden Pilotströme $I_{P1}$, $I_{P2}$ und den Modulationsstrom $I_{mod}$ so auf den Halbleiterlaser LD schalten, daß die optische Ausgangsleistung $P_{opt}$ gegenphasig amplitudenmoduliert wird. Die spannungsgesteuerten Stromquellen $I_{P1}$, $I_{P2}$, $I_{mod}$ werden gemeinsam von einer Steuerspannung $U_s$ angesteuert.

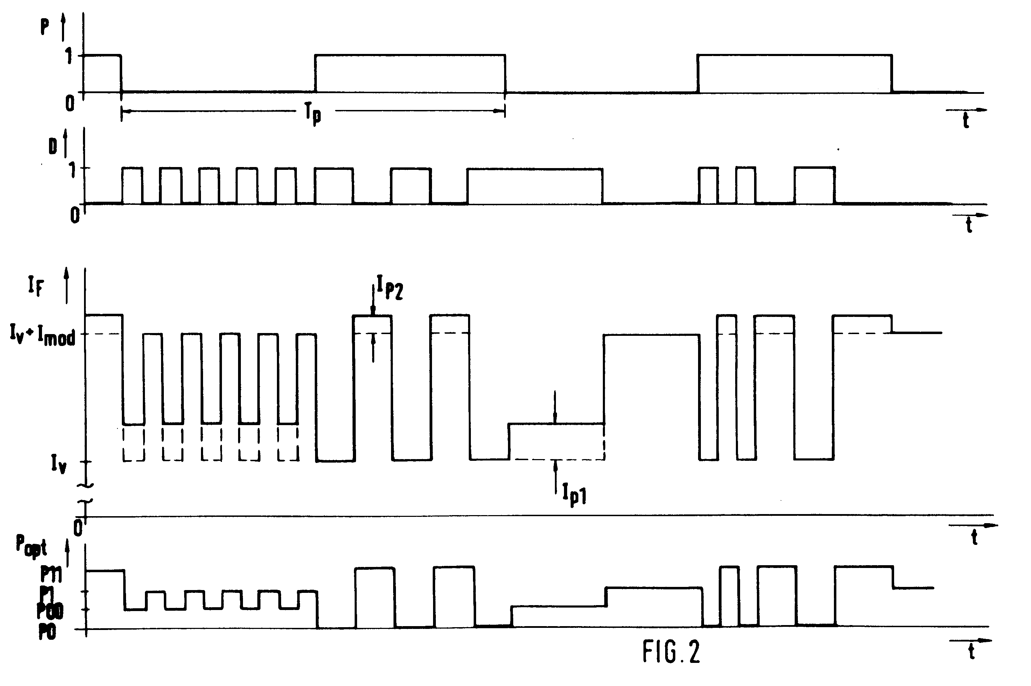

Fig. 2 zeigt den zeitlichen Verlauf des Laserstromes $I_F$ in Abhängigkeit von dem Datensignal D und dem Pilotsignal P für ein beispielhaftes Impulsmuster. Die vier Stromkomponenten $I_v$, $I_{mod}$, $I_{P1}$, $I_{P2}$ werden im Halbleiterlaser LD zum Laserstrom $I_F$ überlagert. Dabei nimmt die optische Ausgangsleistung $P_{opt}$ vier Zustände P0, P1, P00, P11 an.

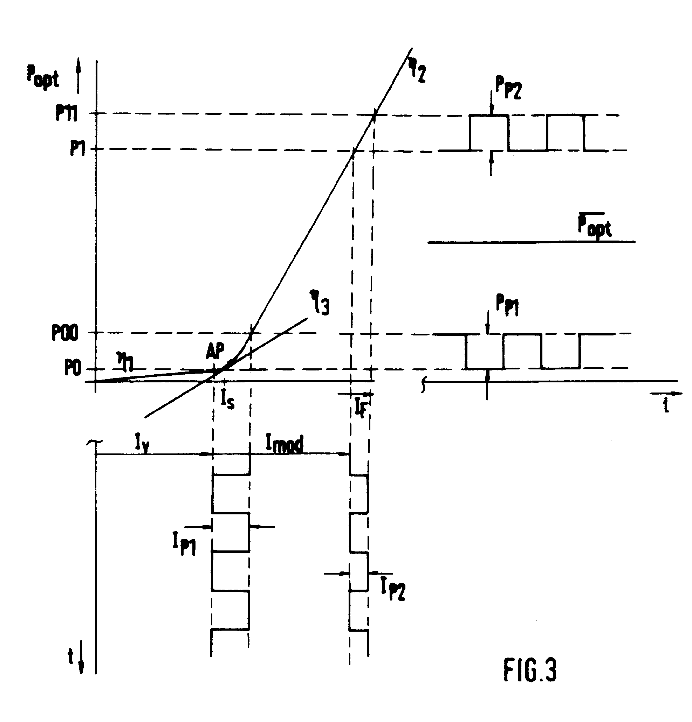

In Fig. 3 ist dieser Sachverhalt mit Hilfe der Laserkennlinie $P_{opt} = f(I_F)$ dargestellt. Die optische Ausgangsleistung $P_{opt}$ ist symmetrisch und gegenphasig amplitudenmoduliert. Da die beiden Modulationshübe $P_{P1}$, $P_{P2}$ gleich sind, weist die mittlere optische Ausgangsleistung $\overline{P}_{opt}$ keine Schwankungen mit der Frequenz des Pilotsignals $fp = \dfrac{1}{Tp}$ auf, so daß im Frequenzspektrum die Spektralkomponente des Pilotsignals fehlt. Dieser in Fig. 3 dargestellte Zustand setzt voraus, daß alle Stromkomponenten auf einen definierten Wert eingestellt sind. Das Verhältnis der beiden Pilotströme $I_{P1} : I_{P2}$ entspricht einem Verhältnis $\eta_2 : \eta_3$, im dargesellten Beispiel $\eta_2 : \eta_3 = 2 : 1$;

wobei $\eta_2$ die Steigung der Laserkennlinie im Aussteuerbereich des oberen optischen Leistungspegels P1 und $\eta_3$ die mittlere Steigung der Laserkennlinie im Aussteuerbereich des unteren optischen Leistungspegels P0 ist.

Der funktionale Zusammenhang der binären Eingangsvariablen Datensignal D und Pilotsignal P mit den vier Zuständen des Laserstromes $I_F$ und der optischen Ausgangsleistung $P_{opt}$ für ein beispielhaftes Impulsmuster des Datensignals D und des Pilotsignals P ist in Fig. 2 dargestellt. In Abhängigkeit der aus vier Möglichkeiten willkürlich gewählten Kombination der Eingangsvariablen D und P überlagern sich die vier Stromkomponenten $I_v$, $I_{mod}$, $I_{P1}$ und $I_{P2}$ zum Laserstrom $I_F$ so, daß sich die optische Ausgangsleistung $P_{opt}$ mit den vier Zuständen P0, P1, P00 und P11 ergibt.

| D | P | IF | $P_{opt}$ |
|---|---|----|------|
| 1 | 1 | $I_v$ | P0 |
| 0 | 0 | $I_v + I_{mod}$ | P1 |
| 1 | 0 | $I_v + I_{P1}$ | P00 |
| 0 | 1 | $I_v + I_{mod} + I_{P2}$ | P11 |

Dabei bedeutet:

| | | |
|---|---|---|
| P0 | Ruheleistung der optischen | "0" |
| P1 | Ruheleistung der optischen | "1" |
| P00 | modulierte Leistung der optischen | "0" |
| P11 | modulierte Leistung der optischen | "1" |

Die drei Differenzverstärker T1, T2; T3, T4; T5, T6 werden nun so angesteuert, daß die oben angegebene Stromüberlagerung für den Laserstrom $I_F$ entsteht. Daraus folgt mit den dem jeweiligen Differenzverstärker zugeordneten Hilfsvariablen $Q_1$, $Q_2$, $Q_3$ folgende Wahrheitstafel:

| D | P | $P_{opt}$ | $Q_1$ | $Q_2$ | $Q_3$ |
|---|---|-----------|-------|-------|-------|
| 0 | 0 | P1 | 0 | 0 | 1 |
| 0 | 1 | P11 | 1 | 0 | 1 |
| 1 | 0 | P00 | 0 | 1 | 0 |
| 1 | 1 | P0 | 0 | 0 | 0 |

Aus der Wahrheitstafel sind die folgenden disjunktiven Normalformen zu entnehmen:

$$Q_1 = \overline{D} \cdot P$$

$$Q_2 = D \cdot \overline{P}$$

$$Q_3 = \overline{D} \cdot \overline{P} + \overline{D} \cdot P$$

Für $Q_3$ gilt:

$$Q_3 = \overline{D} \, (\overline{P} + P)$$
$$= \overline{D}$$

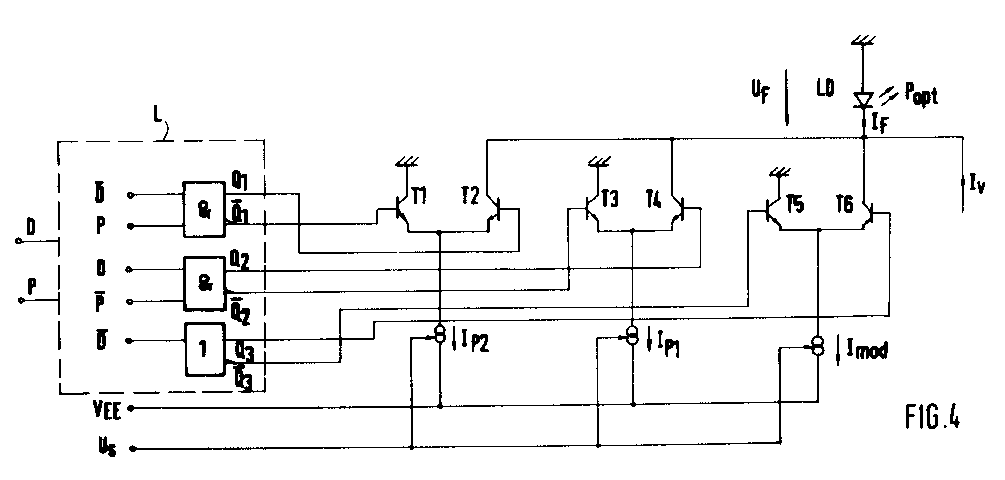

Die entsprechende schaltungstechnische Realisierung mit UND-Gattern zeigt Fig. 4.

Weitere Realisierungsmöglichkeiten ergeben sich aus Umformungen der oben genannten Normalformen mit Hilfe der Booleschen Algebra, beispielsweise

$$\overline{Q_1} = \overline{D} \bullet P \qquad\qquad \overline{Q_2} = D \bullet \overline{P}$$

$$= D + \overline{P} \qquad\qquad\quad = \overline{D} + P$$

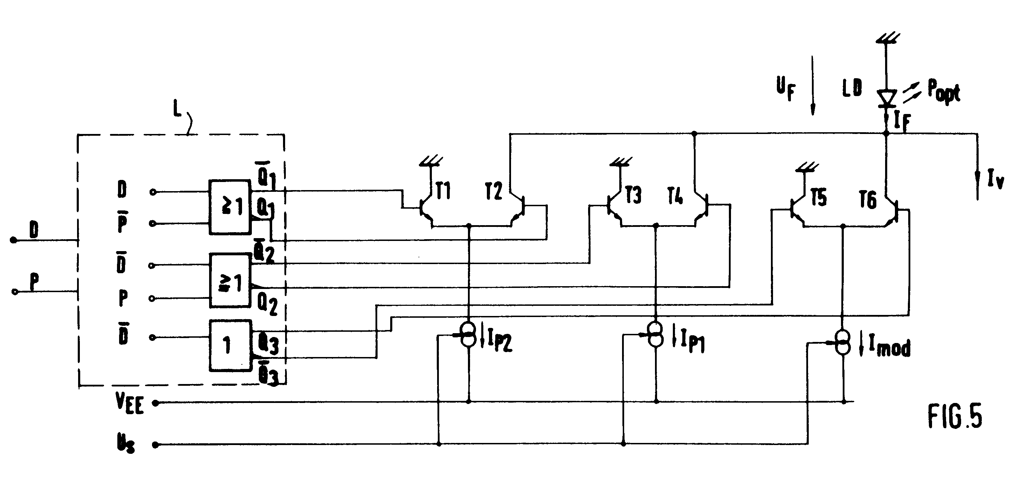

Fig. 5 zeigt die daraus folgende Realisierungsform mit ODER-Gattern.

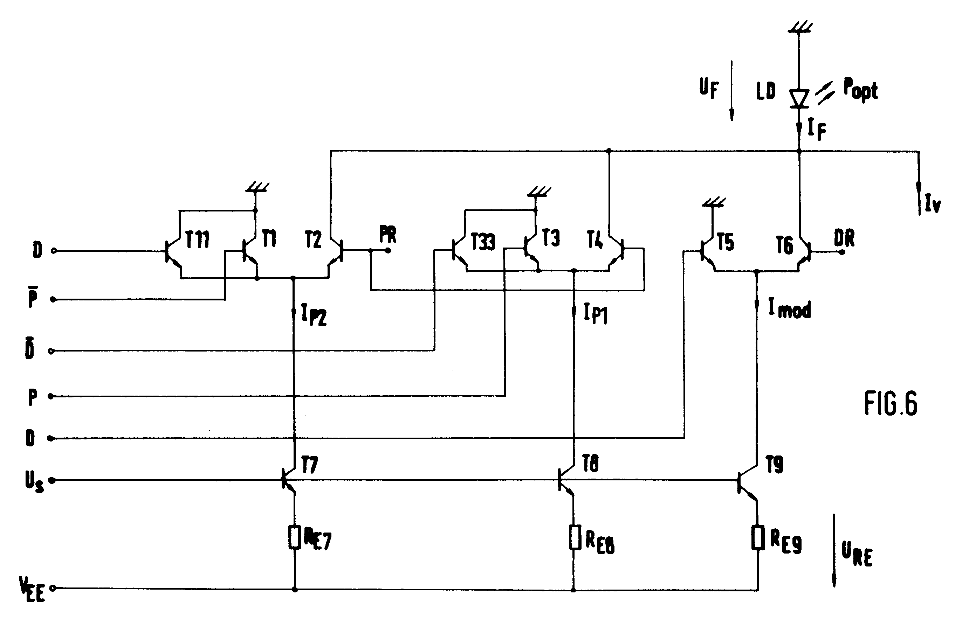

Eine vorteilhafte schaltungstechnische Realisierung der Ansteuerschaltung des Halbleiterlasers LD ist in Fig. 6 dargestellt. Der Kollektor-Emitter-Strecke des ersten Transistors T1 des ersten Differenzverstärkers T1, T2 und der Kollektor-Emitter-Strecke des ersten Transistors T3 des zweiten Differenzverstärkers T3, T4 ist jeweils ein weiterer Transistor T11, T33 mit seiner Kollektor-Emitter-Strecke parallel geschaltet, so daß mit dieser Anordnung die ODER-Funktionen realisiert werden.

Die Differenzverstärker werden von der Betriebsspannungsquelle $V_{EE}$ jeweils über eine spannungsgesteuerte Stromquelle, die aus einer Reihenschaltung aus einem Transistor T7, T8, T9 und einem Emitterwiderstand $R_{E7}$, $R_{E8}$, $R_{E9}$ besteht, gespeist. Die Verhältnisse der drei Ströme $I_{mod} : I_{P1} : I_{P2}$ der spannungsgesteuerten Stromquellen werden im wesentlichen durch entsprechende Dimensionierung der jeweiligen Emitterwiderstände $R_{E7}$, $R_{E8}$, $R_{E9}$ bestimmt. Um die geforderte Amplitudenmodulation des Laserstromes $I_F$ zu erzielen, werden die Differenzverstärker wie folgt angesteuert: Der erste Differenzverstärker T11, T1, T2, der vom zweiten Pilotstrom $I_{P2}$ gespeist wird, wird über die ODER-Funktion des ersten Eingangs von dem Datensignal D und dem negierten Pilotsignal $\overline{P}$ angesteuert, am zweiten Eingang liegt ein konstantes Referenzsignal PR.

Der zweite Differenzverstärker T33, T3, T4, der vom ersten Pilotstrom $I_{P1}$ gespeist wird, wird über die ODER Funktion des ersten Eingangs von dem negierten Datensignal $\overline{D}$ und dem Pilotsignal P angesteuert, am zweiten Eingang liegt ebenfalls das konstante Referenzsignal PR. Der dritte Differenzverstärker T5, T6 wird an seinem ersten Eingang von dem Datensignal D angesteuert, an seinem zweiten Eingang liegt das negierte Datensignal $\overline{D}$ oder ein konstantes Referenzsignal DR.

Diese Schaltungsanordnung hat den Vorteil, daß die beiden Pilotströme $I_{P1}$, $I_{P2}$ besonders einfach für eine Pilotregelung bereitgestellt werden ohne den mit hoher Geschwindigkeit schaltenden dritten Differenzverstärker T5, T6 für den Modulationsstrom $I_{mod}$ störend zu beeinflussen.

Das Verhältnis der Pilotströme $I_{P1} : I_{P2}$ entspricht dem Verhältnis $\eta_2 : \eta_3$, vgl. Fig. 3. Der Modulationsgrad der Amplitudenmodulation $m = I_{P2} : I_{mod}$ wird durch das Amplitudenverhältnis von überlagertem zweiten Pilotstrom $I_{P2}$ und Modulationsstrom $I_{mod}$ eingestellt. Der Gleichlauf der Pilotströme $I_{P1}$, $I_{P2}$ wird mit hoher Genauigkeit erzielt, wenn das Verhältnis der Emitterflächen $A_{E7} : A_{E8}$ der Tranistoren T7, T8 der ersten und der zweiten spannungsgesteuerten Stromquelle gleich dem Verhältnis der ihnen zugeordneten Pilotströme $I_{P2} : I_{P1}$ gewählt wird. Die Temperaturgänge der ersten und zweiten spannungsgesteuerten Stromquelle kompensieren sich dann und die optische Ausgangsleistung $P_{opt}$ des Halbleiterlasers LD wird abgleichfrei und temperaturunabhängig über den gesamten Betriebstemperaturbereich symmetrisch und gegenphasig amplitudenmoduliert.

Falls sich die Steigung $\eta_2$ der Laserkennlinie im Aussteuerbereich des oberen optischen Leistungspegels P1 ändert, so wird die Amplitudenmodulation der optischen Ausgangsleistung $P_{opt}$ asymmetrisch, die mittlere optische Ausgangsleistung $\overline{P_{opt}}$ schwankt mit der Frequenz $f_p$ des Pilotsignals, und somit erscheint im Frequenzspektrum die Spektralkomponente des Pilotsignals. Daraus wird über eine hier nicht dargestellte Regelschaltung eine Steuerspannung $U_s$ abgeleitet, mit der die drei spannungsgesteuerten Stromquellen so angesteuert werden, daß die mittlere optische Ausgangsleistung $\overline{P_{opt}}$ unabhängig von der Veränderung der Kennliniensteigung $\eta_2$ konstant bleibt. Dazu muß der zweite Pilotstrom $I_{P2}$ in gleichem Maße wie der Modulationsstrom $I_{mod}$ geändert werden. Der Gleichlauf dieser Ströme wird mit hoher Genauigkeit erreicht, wenn das Verhältnis der Emitterflächen $A_{E7} : A_{E9}$ der Tranistoren T7, T9 der ersten und dritten spannungsgesteuerten Stromquelle gleich dem entsprechenden Stromverhältnis $I_{P2} : I_{mod}$ gewählt wird.

Die Temperaturgänge der Stromquellen kompensieren sich und Modulationsgrad der Amplitudenmodulation und optische Ausgangsleistung $P_{opt}$ des Halbleiterlasers LD sind abgleichfrei und temperaturunabhängig im gesamten Betriebstemperaturbereich konstant.

Es ist problemlos möglich, die Schaltungsanordnung auch dann anzuwenden, wenn die Amplitudenmodulation nicht symmetrisch und nicht gegenphasig sein soll. Je nach Regelverfahren und Einstellung des Vorstromes $I_v$ im Verhältnis zum Schwellenstrom $I_s$ des Lasers LD ist das Verhältnis der Pilotströme $I_{P1} : I_{P2}$ im Vergleich zum zuvor beschriebenen Beispiel unterschiedlich wählbar. Im Grenzfall kann ein Pilotstrom gleich Null werden. Die Amplitudenmodulation kann dann symmetrisch und gleichphasig, asymmetrisch und gegenphasig oder asymmetrisch und gleichphasig sein. Da die optischen Modulationshübe $P_{P1}$, $P_{P2}$ der optischen Ausgangsleistung $P_{opt}$ somit ungleich sind, schwankt die mittlere optische Ausgangsleistung $\overline{P_{opt}}$ mit der Frequenz des Pilotsignals $f_p$. Es tritt dann im Sollzustand eine Komponente im Frequenzspektrum auf, auf deren Amplitude das Regelverfahren ausgelegt werden kann. Bei der beschriebenen Schaltungsanordnung kann die Anzahl der Eingangsvariablen von zwei auf eine beliebige Anzahl n je nach Einsatzfall vergrößert werden. Entsprechend nimmt dann die optische Ausgangsleistung $P_{opt}$ bei einer erweiterten Anzahl von Differenzverstärkern mit zugeordneten Stromquellen nicht nur vier Zustände, sondern maximal $2^n$ Zustände an. Je nach Anzahl n der Eingangsvariablen lassen sich maximal $2^n$ Kombinationen angeben, die jeweils durch eine unterschiedlich aufgebaute logische Schaltung verknüpft werden können. Entsprechend der in Fig. 6 dargestellten Schaltungsanordnung werden in Abhängigkeit von der Anzahl der Eingangsvariablen und in Abhängigkeit von deren logischer Verknüpfung zur Realisierung der ODER-Funktionen Kollektor-Emitter-Strecken weiterer Tranistoren zu den Kollektor-Emitter-Strecken der Differenzverstärker parallel geschaltet.

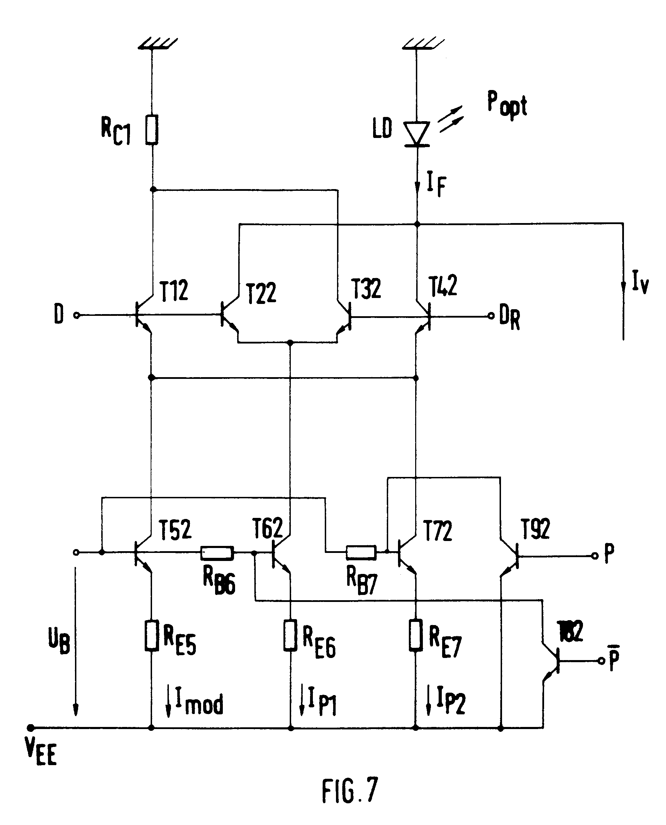

Fig. 7 zeigt eine zweite Schaltungsvariante der Schaltungsanordnung zur Amplitudenmodulation des Ansteuersignals eines Halbleiterlasers LD, die im wesentlichen aus einem ersten Differenzverstärker T12, T42, einem zweiten Differenzverstärker T22, T32 und einer ersten spannungsgesteuerten Stromquelle mit einem Transistor T52 einer zweiten spannungsgesteuerten Stromquelle mit einem Transistor T62 und einer dritten spannungsgesteuerten Stromquelle mit einem Transistor T72 sowie einer ersten und einer zweiten Transistorstufe T82, T92 zur Steuerung eines ersten und eines zweiten Pilotstromes $I_{P1}$, $I_{P2}$ besteht.

Mit dem zu übertragenden Datensignal werden die beiden Differenzverstärker T12, T42; T22, T32 angesteuert. Dazu sind die jeweils entsprechenden Basen der Transistoren T12, T22, T32, T42, d.h. jeweils die ersten und die zweiten Eingänge der Differenzverstärker T12, T42; T22, T32 parallel geschaltet. An den ersten Eingängen liegt das Datensignal D, und an den zweiten Eingängen liegt das negierte Datensignal oder ein konstantes Referenzsignal $D_R$.

Die Kollektoren der Tranistoren T12, T22, T32, T42 sind kreuzweise miteinander verbunden, d.h. der erste Ausgang des ersten Differenzverstärkers T12, T42 ist mit dem zweiten Ausgang des zweiten Differenzverstärkers T22, T32 und der zweite Ausgang des ersten Differenzverstärkers T12, T42 ist mit dem ersten Ausgang des zweiten Differenzverstärkers T22, T32 verbunden. Der erste der so entstehenden Verbindungspunkte ist über die Laserdiode LD und der zweite Verbindungspunkt ist über einen Widerstand $R_{C1}$ mit dem Pluspotential führenden Anschlußpunkt einer Betriebsspannungsquelle verbunden. Dabei kann dieser Widerstand $R_{C1}$ auch entfallen und durch einen Kurzschluß ersetzt werden.

Die Differenzverstärker T12, T42; T22, T32 arbeiten als Stromschalter, d.h. im Großsignalbetrieb, und werden von spannungsgesteuerten Stromquellen gespeist. Der erste Differenzverstärker T12, T42 wird von der ersten spannungsgesteuerten Stromquelle, die einen Modulationsstrom $I_{mod}$ liefert und von der dritten spannungsgesteuerten Stromquelle, die den zweiten Pilotstrom $I_{P2}$ liefert, gespeist. Der zweite Differenzverstärker T22, T32 wird von der zweiten spannungsgesteuerten Stromquelle gespeist, die den ersten Pilotstrom $I_{P1}$ liefert. Die beiden Pilotströme werden durch zwei Pilotsignale P, $\overline{P}$, die jeweils zueinander negiert sind, gegenphasig ein- bzw. ausgeschaltet, indem jeweils ein Pilotsignal über eine Transistorstufe T82, T92 auf die Basis des Transistors T62 der zweiten spannungsgesteuerten Stromquelle und auf die Basis des Transistors T72 der dritten spannungsgesteuerten Stromquelle wirkt. Die Verhältnisse der drei Ströme $I_{mod} : I_{P1} : I_{P2}$ der spannungsgesteuerten Stromquellen werden auch bei dieser Schaltungsvariante im wesentlichen durch entsprechende Dimensionierung der jeweiligen Emitterwiderstände $R_{E5}$, $R_{E6}$, $R_{E7}$ bestimmt. Somit wird durch die Schaltungsanordnung der Halbleiterlaser LD mit dem Vorstrom $I_v$ dem Modulationsstrom $I_{mod}$ und den Pilotströmen $I_{P1}$, $I_{P2}$ versorgt.

Die Werte der Basisvorwiderstände $R_{B6}$, $R_{B7}$ der zweiten und dritten spannungsgesteuerten Stromquelle werden vorteilhafterweise so gewählt, daß einerseits die Basisspannung des Transistors T52 der ersten spannungsgesteuerten Stromquelle beim Schalten des Pilotsignals im wesentlichen unverändert bleibt und daß andererseits die Transistoren T62, T72 der zweiten und dritten spannungsgesteuerten Stromquelle durch die vorgeschalteten Transistorstufen T82, T92 sicher gesperrt werden können. Der Wunsch nach geringem Leistungsumsatz führt dazu, die Baisvorwiderstände $R_{B6}$, $R_{B7}$ möglichst hochohmig zu wählen.

Der Gleichlauf der Pilotströme $I_{P1}$, $I_{P2}$ wird mit hoher Genauigkeit erzielt wenn das Widerstandsverhältnis der Basiswiderstände $R_{B6} : R_{B7}$ der Transistoren T62, T72 der zweiten und dritten spannungsgesteuerten Stromquelle gleich dem umgekehrten Verhältnis der den spannungsgesteuerten Stromquellen zugeordneten Pilotströme $I_{P1} : I_{P2}$ gewählt wird und das Verhältnis der Emitterflächen der genannten Transistoren $A_{E6} : A_{E7}$ gleich dem Verhältnis der der zweiten und der dritten Stromquelle zugeordneten Pilotströme $I_{P1} : I_{P2}$ gewählt wird. Die Temperaturgänge der zweiten und dritten spannungsgesteuerten Stromquelle kompensieren sich dann, und die optische Ausgangsleistung $P_{opt}$ des Halbleiterlasers LD wird abgleichfrei und temperaturunabhängig über den gesamten Betriebstemperaturbereich symmetrisch und gegenphasig amplitudenmoduliert.

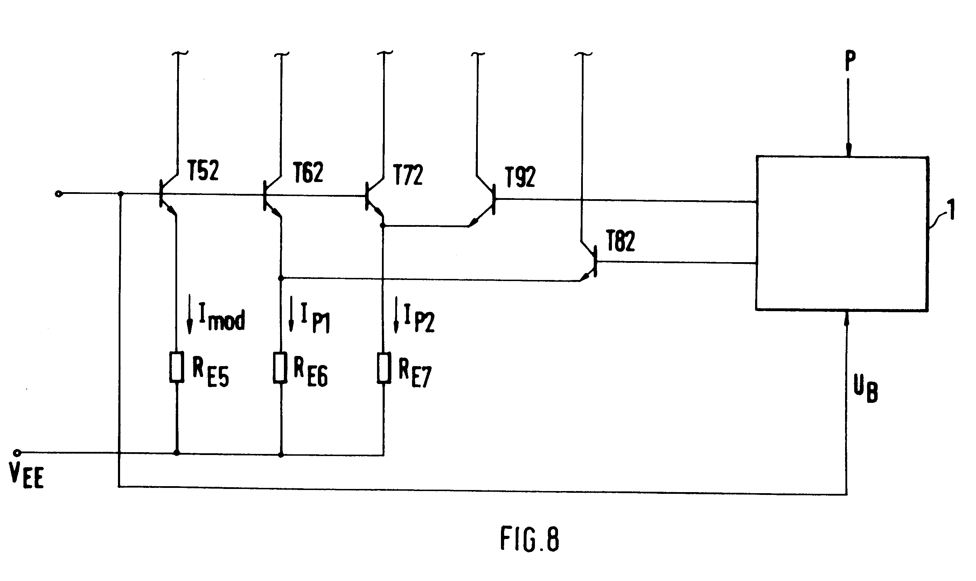

Gemäß Fig. 8 ist es möglich, die Transistoren T62, T72 der zweiten und dritten spannungsgesteuerten Stromquelle über die Emitter anzusteuern. Dann entfallen die Basisvorwiderstände $R_{B6}$, $R_{B7}$. Ein Vorteil dieser Schaltungsvariante ist dann das günstige Schaltverhalten der Transistoren T62, T72, so daß die Pilotsignalfrequenz bis in die Größenordnung der Frequenz des Datensignals gesteigert werden kann. Die Ansteuerung der Transistorstufen T82, T92 für die Pilotsignale muß für maximale Basisspannung der Transistoren T52, T62, T72 der spannungsgesteuerten Stromquellen ausgelegt sein oder kann wie in Fig. 8 gezeigt, über eine von der Steuerspannung $U_B$ der spannungsgesteuerten Stromquellen funktionell abhängige Ansteuerschaltung 1 erfolgen.

Der zuvor anhand der Fig. 2 und Fig. 3 dargestelle Sachverhalt für die erste Schaltungsvariante trifft gleichermaßen auch für die zweite Schaltungsvariante zu. Ebenso gelten in gleicher Weise die Ausführungen zur Wahl der Pilotströme, wenn die Amplitudenmodulation nicht symmetrisch und nicht gegenphasig sein soll.

## Patentansprüche

1. Schaltungsanordnung zur Amplitudenmodulation des Ansteuersignals eines Halbleiterlasers (LD), die aus einer Kaskadenschaltung aus Differenzverstärkern und Stromquellen besteht, mit der der Modulationsstrom ($I_{mod}$) des Lasers (LD) mit zwei Pilotströmen ($I_{P1}$, $I_{P2}$) amplitudenmoduliert wird, **dadurch gekennzeichnet**, daß in einer ersten Kaskadenstufe als Stromschalter wirkende Differenzverstärker und in einer zweiten Kaskadenstufe die die Differenzverstärker speisenden Stromquellen angeordnet sind, und daß ein zur Steuerung des Modulationsstromes ($I_{mod}$) dienendes Datensignal (D) mit einem zur Steuerung der Pilotströme ($I_{P1}$, $I_{P2}$) dienendes Pilotsignal (P) in mindestens einer der Kaskadenstufen miteinander logisch verknüpft sind.

2. Schaltungsanordnung nach Anspruch 1,
dadurch gekennzeichnet, daß ein erster (T1, T2), ein zweiter (T3, T4) und ein dritter Differenzverstärker (T5, T6) so zusammengeschaltet sind, daß die jeweiligen ersten Ausgänge mit dem ersten Pol einer Betriebsspannungsquelle und die jeweiligen zweiten Ausgänge über den Laser (D) mit dem ersten Pol der Betriebsspannungsquelle verbunden sind und die Eingänge der Differenzverstärker (T1, T2; T3, T4; T5, T6) an eine von einem Datensignal (D) und einem Pilotsignal (P) gesteuerte kombinatorische Logikschaltung (L) geschaltet sind und daß jeder Differenzverstärker (T1, T2; T3, T4; T5, T6) jeweils über eine spannungsgesteuerte Stromquelle ($I_{P1}$, $I_{P2}$, $I_{mod}$) mit dem zweiten Pol der Betriebsspannungsquelle ($V_{EE}$) verbunden ist und die spannungsgesteuerten Stromquellen ($I_{P1}$, $I_{P2}$, $I_{mod}$) mit ihrem Steuereingang gemeinsam an den Ausgang einer Steuerschaltung geschaltet sind.

3. Schaltungsanordnung nach Anspruch 2,
dadurch gekennzeichnet, daß der erste Differenzverstärker (T1, T2) mit der den zweiten Pilotstrom liefernden ersten spannungsgesteuerten Stromquelle ($I_{P2}$), der zweite Differenzverstärker (T3, T4) mit der den ersten Pilotstrom liefernden zweiten spannungsgesteuerten Stromquelle (I_{P1}) und der dritte Differenzverstärker (T5, T6) mit der den Modulationsstrom liefernden dritten spannungsgesteuerten Stromquelle (I_{mod}) verbunden ist.

4. Schaltungsanordnung nach den Anspruch 3,
dadurch gekennzeichnet, daß die Differenzverstärker (T1, T2; T3, T4; T5, T6) jeweils aus einem ersten (T1, T3, T5) und einem zweiten Transistor (T2, T4, T6) bestehen, daß zur Kollektor-Emitter-Strecke des ersten Transistors (T1) des ersten Differenzverstärkers (T1, T2) und zur Kollektor-Emitter-Strecke des ersten Transistors (T3) des zweiten Differenzverstärkers (T3, T4) die Kollektor-Emitter-Strecke eines jeweiligen dritten Transistors (T11, T33) parallel geschaltet ist und daß die Basisanschlüsse der Transistoren der Differenzverstärker wie folgt beschaltet sind: Die Basis des dritten Transistors (T11) des ersten Differenzverstärkers und die Basis des ersten Transistors (T5) des dritten Differenzverstärkers mit dem Datensignal (D), die Basis des ersten Transistors (T1) des ersten Differenzverstärkers mit dem negierten Pilotsignal ($\overline{P}$), die Basis des zweiten Transistors (T2) des ersten Differenzverstärkers und die Basis des zweiten Transistors (T4) des zweiten Differenzverstärkers mit einem konstanten Referenzsignal (PR), die Basis des dritten Transistors (T33) des zweiten Differenzverstärkers mit dem negierten Datensignal ($\overline{D}$), die Basis des ersten Transistors (T3) des zweiten Differenzverstärkers mit dem Pilotsignal (P) und die Basis des zweiten Transistors (T6) des dritten Differenzverstärkers mit dem negierten Datensignal ($\overline{D}$) oder einem konstanten Referenzsignal (DR) und daß die spannungsgesteuerten Stromquellen (I_{P1}, I_{P2}, I_{mod}) jeweils aus einer Reihenschaltung aus einem Transistor (T7, T8, T9) und einem Emitterwiderstand (R_{E7}, R_{E8}, R_{E9}) bestehen und die Basisanschlüsse dieser Transistoren gemeinsam an einer Steuerspannung (U_s) liegen.

5. Schaltungsanordnung nach Anspruch 2,
dadurch gekennzeichnet, daß die Anzahl der Eingangsvariablen der kombinatorischen Logikschaltung (L) sowie die Anzahl der Differenzverstärker und der diesen zugeordneten Stromquellen vergrößert werden kann.

6. Schaltungsanordnung nach Anspruch 1,
dadurch gekennzeichnet, daß in einer ersten Kaskadenstufe ein erster (T12, T42) und ein zweiter (T22, T32) Differenzverstärker angeordnet sind, deren erste Eingänge und deren zweite Eingänge jeweils miteinander verbunden sind und deren erste und zweite Ausgänge kreuzweise verbunden sind und daß in einer zweiten Kaskadenstufe eine erste, eine zweite und eine dritte spannungsgesteuerte Stromquelle angeordnet sind, die gemeinsam von einer Steuerspannung (U_B) angesteuert werden, daß die erste spannungsgesteuerte Stromquelle zur Einspeisung des Modulationsstromes (I_{mod}) und die dritte spannungsgesteuerte Stromquelle zur Einspeisung eines zweiten Pilotstromes (I_{P2}) mit dem ersten Differenzverstärker (T12, T42) verbunden sind, daß die zweite spannungsgesteuerte Stromquelle zur Einspeisung eines ersten Pilotstromes (I_{P1}) mit dem zweiten Differenzverstärker (T22, T32) verbunden ist und daß die zweite und dritte spannungsgesteuerte Stromquelle in Abhängigkeit von einem Pilotsignal (P, $\overline{P}$) über eine Transistorstufe (T82, T92) jeweils wechselweise aktiviert werden.

7. Schaltungsanordnung nach Anspruch 6,
dadurch gekennzeichnet, daß die Steuerspannung (U_B) an der Basis des Transistors (T52) der ersten spannungsgesteuerten Stromquelle und jeweils über einen Widerstand (R_{B6}, R_{B7}) an der Basis der Transistoren (T62, T72) der zweiten und dritten spannungsgesteuerten Stromquelle anliegt.

8. Schaltungsanordnung nach Anspruch 6,
dadurch gekennzeichnet, daß die Kollektoren der Transistoren (T52, T72) der ersten und dritten spannungsgesteuerten Stromquelle mit den Emittern der Transistoren (T12, T42) des ersten Differenzverstärkers und der Kollektor des Transistors (T62) der zweiten spannungsgesteuerten Stromquelle mit den Emittern der Transistoren (T22, T32) des zweiten Differenzverstärkers verbunden ist.

9. Schaltungsanordnung nach Anspruch 6,
dadurch gekennzeichnet, daß der Kollektor des Transistors (T82) der ersten Transistorstufe mit der Basis des Transistors (T62) der zweiten spannungsgesteuerten Stromquelle und daß der Kollektor des Transistors (T92) der zweiten Transistorstufe mit der Basis des Transistors (T72) der dritten spannungsgesteuerten Stromquelle verbunden ist und daß der Emitter des Transistors (T82) der ersten Transistorstufe und der Emitter des Transistors (T92) der zweiten Transistorstufe jeweils an den negativen Pol einer Betriebsspannungsquelle geschaltet ist.

**10.** Schaltungsanordnung nach Anspruch 6,
dadurch gekennzeichnet, daß der Emitter des Transistors (T82) der ersten Transistorstufe mit dem Emitter des Transistors (T62) der zweiten spannungsgesteuerten Stromquelle und daß der Emitter des Transistors (T92) der zweiten Transistorstufe mit dem Emitter des Transistors (T72) der dritten spannungsgesteuerten Stromquelle verbunden ist und daß die erste und zweite Transistorstufe an eine das Pilotsignal (P) übertragende und von der Steuerspannung (U$_B$) der spannungsgesteuerten Stromquellen gesteuerten Ansteuerschaltung (1) geschaltet sind und daß die Emitter der Transistoren (T52, T62, T72) der ersten, zweiten und dritten spannungsgesteuerten Sromquelle jeweils über einen Emitterwiderstand (R$_{E5}$, R$_{E6}$ R$_{E7}$) an den negativen Pol einer Betriebsspannungsquelle angeschlossen sind.

## Claims

**1.** A circuit arrangement for amplitude-modulating the drive signal of a semiconductor laser (LD), comprising a cascade of differential amplifiers and current sources which amplitude-modulates the modulating current (I$_{mod}$) of the laser (LD) with two pilot currents (I$_{P1}$, I$_{P2}$),
characterized in that a first cascade stage includes differential amplifiers acting as current switches, that a second cascade stage includes the current sources feeding the differential amplifiers, and that in at least one cascade stage, a data signal (D) serving to control the modulating current (I$_{mod}$) is logically combined with a pilot signal (P) serving to control the pilot currents (I$_{P1}$, I$_{P2}$).

**2.** A circuit arrangement per Claim 1,
characterized in that a first (T1, T2), a second (T3, T4) and a third differential amplifier (T5, T6) are interconnected such that the first output of each differential amplifier is connected to the first pole of an operating voltage source and that each second output is connected via the laser (D) to the first pole of the operating voltage source and that the inputs of the differential amplifiers (T1, T2; T3, T4; T5, T6) are connected to a combinatorial logical circuit (L) controlled by a data signal (D) and a pilot signal (P) and that the differential amplifiers (T1, T2; T3, T4; T5, T6) are each connected to the second pole of the operating voltage source (V$_{EE}$) via a voltage-controlled current source (I$_{P1}$, I$_{P2}$, I$_{mod}$) and that the voltage-controlled current sources (I$_{P1}$, I$_{P2}$, I$_{mod}$) are jointly connected at their control inputs to the output of a control circuit.

**3.** A circuit arrangement per Claim 2,
characterized in that the first differential amplifier (T1, T2) is connected to the first voltage-controlled current source (I$_{P2}$) supplying the second pilot current, the second differential amplifier (T3, T4) is connected to the second voltage-controlled current source (I$_{P1}$) supplying the first pilot current, and that the third differential amplifier (T5, T6) is connected to the third voltage-controlled current source (I$_{mod}$) supplying the modulating current.

**4.** A circuit arrangement per Claim 3
characterized in that the differential amplifiers (T1, T2; T3, T4; T5, T6) each comprise a first (T1, T3, T5) and a second transistor (T2, T4, T6), that the collector-emitter path of a third transistor (T11, T33) is connected in parallel respectively to the collector-emitter path of the first transistor (T1) of the first differential amplifier (T1, T2) and to the collector-emitter path of the first transistor (T3) of the second differential amplifier (T3, T4) and that the base terminals of the transistors of the differential amplifiers are connected as follows: the base of the third transistor (T11) of the first differential amplifier and the base of the first transistor (T5) of the third differential amplifier to the data signal (D), the base of the first transistor (T1) of the first differential amplifier to the negated pilot signal (P), the base of the second transistor (T2) of the first differential amplifier and the base of the second transistor (T4) of the second differential amplifier to a constant reference signal (PR), the base of the third transistor (T33) of the second differential amplifier to the negated data signal ($\overline{D}$), the base of the first transistor (T3) of the second differential amplifier to the pilot signal (P) and the base of the second transistor (T6) of the third differential amplifier to the negated data signal ($\overline{D}$) or to a constant reference signal (D$_R$) and that the voltage-controlled current sources (I$_{P1}$, I$_{P2}$, I$_{mod}$) each comprise a series circuit of a transistor (T7, T8, T9) and an emitter resistor (R$_{E7}$, R$_{E8}$, R$_{E9}$) and that the base terminals of these transistors are jointly kept at a control voltage (U$_S$).

**5.** A circuit arrangement per Claim 2,
characterized in that the number of the input variables of the combinatorial logical circuit (L) as well as the number of differential amplifiers and current sources associated with these can be augmented.

6. A circuit arrangement per Claim 1,
   characterized in that a first (T12, T42) and a second (T22, T32) differential amplifier are arranged in a first cascade stage and that the first inputs and the second inputs respectively of these differential amplifiers are connected to each other and that the first and second outputs of these differential amplifiers are cross-connected and that a second and a third voltage-controlled current source are arranged in a second cascade stage and jointly controlled by means of a control voltage ($U_B$), that the first voltage-controlled current source for feeding the modulating current ($I_{mod}$) and the third voltage-controlled current source for feeding a second pilot current ($I_{P2}$) are connected to the first differential amplifier (T12, T42), that the second voltage-controlled current source for feeding a first pilot current ($I_{P1}$) is connected to the second differential amplifier (T22, T32) and that the second and third voltage-controlled current sources respectively are each alternately activated via a transistor stage (T82, T92) contingent upon a pilot signal ($P, \overline{P}$).

7. A circuit arrangement per Claim 6,
   characterized in that the control voltage ($U_B$) is located adjacent to the base of the transistor (T52) of the first voltage-controlled current source and located adjacent to the base of the transistors (T62, T72) of the second and third voltage-controlled current source via a resistor ($R_{B6}, R_{B7}$) respectively.

8. A circuit arrangement per Claim 6,
   characterized in that the collectors of the transistors (T52, T72) of the first and third voltage-controlled current sources are connected to the emitters of the transistors (T12, T42) of the first differential amplifier and that the collector of the transistor (T62) of the second voltage-controlled current source is connected to the emitters of the transistors (T22, T32) of the second differential amplifier.

9. A circuit arrangement per Claim 6,
   characterized in that the collector of the transistor (T82) of the first transistor stage is connected to the base of the transistor (T62) of the second voltage-controlled current source and that the collector of the transistor (T92) of the second transistor stage is connected to the base of the transistor (T72) of the third voltage-controlled current source and that the emitter of the transistor (T82) of the first transistor stage and the emitter of the transistor (T92) of the second transistor stage respectively are wired to the negative pole of an operating voltage source.

10. A circuit arrangement per Claim 6,
    characterized in that the emitter of the transistor (T82) of the first transistor stage is connected to the emitter of the transistor (T62) of the second voltage-controlled current source and that the emitter of the transistor (T92) of the second transistor stage is connected to the emitter of the transistor (T72) of the third voltage-controlled current source and that the first and second transistor stages are wired to a drive circuit (1) controlled by the control voltage ($U_B$) of the voltage-controlled current source and which transmits the pilot signal (P) and that the emitters of the transistors (T52, T62, T72) of the first, second and third voltage-controlled current source respectively are connected to the negative pole of an operating voltage source via an emitter resistor ($R_{E5}, R_{E6}, R_{E7}$).

**Revendications**

1. Dispositif de circuit pour la modulation d'amplitude du signal de commande d'un laser à semi-conducteur (LD), qui est constitué d'un circuit en cascade constitué d'amplificateurs différentiels et de sources de courant et avec lequel le courant de modulation (Imod) du laser (LD) est modulé en amplitude par deux courants pilotes ($I_{P1}, I_{P2}$).
   caractérisé par le fait que, dans un premier étage de la cascade, sont disposés les amplificateurs différentiels agissant comme commutateurs de courant et, dans un second étage de la cascade, sont disposées les sources de courant alimentant les amplificateurs différentiels, et qu'un signal de données (D), servant à la commande du courant de modulation ($I_{mod}$), est logiquement relié à un signal pilote (P), servant à la commande des courants pilotes ($I_{P1}, I_{P2}$), dans au moins l'un des étages de la cascade.

2. Dispositif de circuit selon la revendication 1,
   caractérisé par le fait qu'un premier (T1, T2), un second (T3, T4) et un troisième (T5, T6) amplificateurs différentiels sont mis en circuit ensemble de façon telle que chacune des premières sorties sont reliées avec le premier pôle d'une source de tension d'exploitation et que chacune des secondes sorties sont reliées, par l'intermédiaire du laser (D), avec le premier pôle de la source de tension d'exploitation et que les entrées des amplificateurs différentiels (T1, T2; T3, T4; T5, T6) sont reliées à un circuit logique combinatoire (L) commandé par un signal de données (D) et un signal pilote (P) et que chaque amplificateur différentiel (T1, T2. T3, T4; T5, T6) est relié, par l'intermédiaire, chacun, d'une source de courant commandée en tension ($I_{P1}$, $I_{P2}$, $I_{mod}$), avec le second pôle de la source de tension d'exploitation (VEE) et que les sources de courant, commandées en tension, ($I_{P1}$, $I_{P2}$, $I_{mod}$) sont reliées en commun, par leur entrée de commande, à la sortie d'un circuit de commande.

3. Dispositif de circuit selon la revendication 2,

caractérisé par le fait que le premier amplificateur différentiel (T1, T2) est relié avec la première source de courant, commandée en tension, ($I_{P2}$) qui fournit le second courant pilote, que le second amplificateur différentiel (T3, T4) est relié avec la seconde source de courant, commandée en tension, ($I_{P1}$) qui fournit le premier courant pilote et que le troisième amplificateur différentiel (T5, T6) est relié avec la troisième source de courant, commandée en tension, ($I_{mod}$) qui fournit le courant de modulation.

4. Dispositif de circuit selon la revendication 3,

caractérisé par le fait que les amplificateurs différentiels (T1, T2; T3, T4; T5, T6) sont chacun constitués d'un premier (T1, T3, T5) et d'un second (T2, T4, T6) transistors, qu'en parallèle à l'élément de circuit collecteur-émetteur du premier transistor (T1) des premiers amplificateurs différentiels (T1, T2), et en parallèle à l'élément de circuit collecteur-émetteur du premier transistor (T3) du second amplificateur différentiel (T3, T4), est respectivement mis en circuit l'élément de circuit collecteur-émetteur d'un troisième transistor respectif (T11, T33) et que les bornes des bases des transistors et des amplificateurs différentiels sont reliées comme suit: la base du troisième transistor (T11) du premier amplificateur différentiel et la base du premier transistor (T5) du troisième amplificateur différentiel le sont avec le signal de données (D), la base du premier transistor (T1) du premier amplificateur différentiel l'est avec le signal pilote, changé de signe, ($\overline{P}$), la base du second transistor (T2) du premier amplificateur différentiel et la base du second transistor (T4) du second amplificateur différentiel le sont avec un signal de référence constant (PR), la base du troisième transistor (T33) du second amplificateur différentiel l'est avec le signal de données, changé de signe ($\overline{D}$), la base du premier transistor (T3) du second amplificateur différentiel l'est avec le signal pilote (P) et la base du second transistor (T6) du troisième amplificateur différentiel l'est avec le signal de données, changé de signe ($\overline{D}$) ou avec un signal de référence constant (DR) et que les sources de courant, commandées en tension, ($I_{P1}$, $I_{P2}$, $I_{mod}$) sont chacune constituées d'un circuit de série constitué d'un transistor (T7, T8, T9) et d'une résistance ($R_{E7}$, $R_{E8}$, $R_{E9}$) liée à l'émetteur et que les bornes de la base de ces transistors sont reliées en commun à une tension de commande ($U_S$).

5. Dispositif de circuit selon la revendication 2,

caractérisé par le fait que l'on peut augmenter le nombre des variables d'entrée du circuit logique combinatoire (L) ainsi que le nombre des amplificateurs différentiels et des sources de courant correspondant à ceux-ci.

6. Dispositif de circuit selon la revendication 1,

caractérisé par le fait que dans un premier étage de la cascade sont disposés un premier (T12, T42) et un second (T22, T32) amplificateurs différentiels, dont les premières entrées sont reliées entre elles, ainsi que les secondes entrées, et dont la première sortie de l'un est reliée en croix avec la seconde sortie de l'autre, et que dans un second étage de la cascade sont disposées une première, une seconde et une troisième sources de courant, commandées en tension, qui sont commandées en commun par une tension de commande ($U_B$), que la première source de courant, commandée en tension et prévue pour l'alimentation du courant de modulation ($I_{mod}$), est reliée avec le premier amplificateur différentiel (T12, T42) ainsi que la troisième source de courant, commandée en tension est prévue pour l'alimentation d'un second courant pilote ($I_{P2}$), que la seconde source de courant, commandée en tension et prévue pour l'alimentation d'un premier courant pilote ($I_{P1}$) est reliée avec le second amplificateur différentiel (T22, T32) et que la seconde et la troisième sources de courant, commandées en tension, sont alternativement chacune activées, en fonction d'un signal pilote (P, $\overline{P}$), par l'intermédiaire d'un étage de transistors (T82, T92).

7. Dispositif de circuit selon la revendication 6,

caractérisé par le fait que la tension de commande ($U_B$) arrive à la base du transistor (T52) de la première source de courant, commandée en tension, et par l'intermédiaire chaque fois d'une résistance ($R_{B6}$, $R_{B7}$), à la base des transistors (T62, T72) de la seconde et de la troisième sources de courant, commandées en tension.

8. Dispositif de circuit selon la revendication 6, caractérisé par le fait que les collecteurs des transistors (T52, T72) de la première et de la troisième sources de courant, commandées en tension, sont reliés avec les émetteurs des transistors (T12, T42) du premier amplificateur différentiel et que le collecteur du transistor (T62) de la seconde source de courant, commandée en tension, est reliée avec les émetteurs des transistors (T22, T32) du second amplificateur différentiel.

9. Dispositif de circuit selon la revendication 6,
caractérisé par le fait que le collecteur du transistor (T82) du premier étage de transistors est relié à la base du transistor (T62) de la seconde source de courant, commandée en tension, et que le collecteur du transistor (T92) du second étage de transistors est relié à la base du transistor (T72) de la troisième source de courant, commandée en tension, et que l'émetteur du transistor (T82) du premier étage de transistors et l'émetteur du transistor (T92) du second étage de transistors sont, chacun, reliés au pôle négatif d'une source de tension d'exploitation.

10. Dispositif de circuit selon la revendication 6,
caractérisé par le fait que l'émetteur du transistor (T82) du premier étage de transistors est relié à l'émetteur du transistor (T62) de la seconde source de courant, commandée en tension, et que l'émetteur du transistor (T92) du second étage de transistors est relié à l'émetteur du transistor (T72) de la troisième source de courant, commandée en tension, et que le premier et le second étages de transistors sont reliés à un circuit de commande (I) qui transmet le signal pilote (P) et qui est commandé par la tension de commande ($U_B$) des sources de courant commandées en tension et que les émetteurs des transistors (T52, T62, T72) de la première, de la seconde et de la troisième sources de courant, commandées en tension, sont, chacun par l'intermédiaire d'une résistance ($R_{E5}$, $R_{E6}$, $R_{E7}$) liée à l'émetteur, reliés aux pôles négatifs d'une source de tension d'exploitation.

FIG.1

FIG.2

FIG.3

FIG.4

FIG.5

FIG.6

FIG.7

FIG.8